# EUROPÄISCHE PATENTSCHRIFT

(11) **EP 1 867 021 B1**
(45) Veröffentlichungstag und Bekanntmachung des Hinweises auf die Patenterteilung: **13.01.2010**
(21) Anmeldenummer: 06723744.6
(22) Anmeldetag: 25.03.2006
(51) Int. Cl.: H02B 1/36

(54) **ELEKTRISCHE SCHALTANLAGE UND BASISMODUL FÜR EINE ELEKTRISCHE SCHALTANLAGE**
ELECTRIC SWITCHING SYSTEM AND BASE MODULE FOR AN ELECTRIC SWITCHING SYSTEM
INSTALLATION DE DISTRIBUTION ELECTRIQUE ET MODULE DE BASE POUR INSTALLATION DE DISTRIBUTION ELECTRIQUE

(30) Priorität: 08.04.2005 DE 102005016543
(43) Veröffentlichungstag der Anmeldung: 19.12.2007
(73) Patentinhaber: ABB AG, 68309 Mannheim (DE)
(72) Erfinder: MATHES, Werner, 67227 Frankenthal (DE); KRAFT, Klaus, 69123 Heidelberg (DE); SCHMITT, Hans-Jürgen, 69493 Hirschberg (DE)
(86) Internationale Anmeldenummer: PCT/EP2006/002766
(87) Internationale Veröffentlichungsnummer: WO 2006/105883

(56) Entgegenhaltungen:
- EP-A2- 0 109 569
- EP-A2- 0 109 584
- DE-A1- 2 515 164
- DE-A1- 19 511 648
- DE-A1- 19 523 592
- US-A- 5 691 686

## Beschreibung

Die Erfindung betrifft eine elektrische Schaltanlage mit einem Gehäuse und mit darin angeordneten Komponenten, die als Steuer- und/oder Messeinheit ausgebildet sind, wobei die Komponenten in modulartigen Einschüben angeordnet sind, welche ein als Bodenteil dienendes Modultragprofil sowie bedarfsweise seitliche Begrenzungen aufweisen, sowie ein Basismodul für eine solche Schaltanlage.

Elektrische Schaltanlagen heutiger Bauart sind überwiegend in so genannter Einschubtechnik gestaltet, das heißt, alle elektrischen Betriebsmittel und - einrichtungen, zum Beispiel die als Komponenten eingebauten Steuer- und Messeinrichtungen, werden auf vorzugsweise modularisierten Einschüben angeordnet.

Dies hat einerseits den Vorteil einer erleichterten Zugänglichkeit, indem das betreffende Einschub-Modul im Bedarfsfall, zum Beispiel Störfall, aus dem jeweiligen Gehäuse herausgezogen werden kann und somit ohne große Demontagearbeiten repariert, ausgewechselt oder ersetzt werden kann.

Andererseits hat die bekannte modularisierte Einschubtechnik den Nachteil eines großen Raumbedarfs, da die Größe der Einschubmodule üblicherweise auf die größte zum Einsatz vorgesehene Komponente zugeschnitten sind, so dass vielfach wegen der geringeren Größe anderer Komponenten nicht benötigter Raum in den Schaltschränken ungenutzt bleibt beziehungsweise die Schaltanlagen unnötig groß dimensioniert werden müssen.

Aus der DE 195 23 592 ist eine Niederspannungs-Schaltgerätekombination bekannt, bei welcher eine Gerätehalterung für elektrische Geräte mit einem Lasttrennschalter elektrisch verbunden ist. Dies soll den Vorteil einer einfachen Verbindungstechnik bieten, da die Verbindung der elektrischen Geräte mit der Gerätehalterung erfolgt, welche ihrerseits mit dem Lasttrennschalter verbunden ist.

In der EP 109569 A2 ist beschrieben, wie ein elektrischer Anlagenschrank mit darin einfügbaren Einschüben, die im wesentlichen aus einem Bodenteil mit seitlich daran angrenzenden Abdeckungen sowie je einer Front- und Rückwandung gebildet sind, mittels Verwendung von profilierten Teilen günstig herstellbar ist.

Aus der DE 195 11 648 A1 ist ein Verfahren zur Fertigung von Einschüben für Niederspannungs-Schaltanlagen und Montageplatten hierfür bekannt, das zum Ziel hat, den Zeitaufwand für Verdrahtung und Montage zu verringern, indem die auf der Montageplatte montierten Schaltgeräte mit in den Einschub unmontierten Steckkontakten und unmontierten Frontplattegeräte verdrahtet und anschließend die verdrahteten, aus zwei auf einer Ebene angeordneten Abschnitten bestehenden Montageplatten gebogen oder so gedreht werden, dass die Abschnitte Rücken an Rücken angeordnet sind und in dem betreffenden Einschub eingesetzt und dort befestigt werden können.

Aus der DE 2515164 schließlich ist eine elektrische Schaltanlage für Niederspannung bekannt, deren elektrische Geräte, wie Steuer-, Regel- und Schaltgeräte, in Schaltschränken untergebracht sind, wobei die elektrischen Geräte zu Funktionseinheiten auf Tragrahmen, Einschüben, Einschubfächer oder dergleichen angeordnet und über Kontakte für Last- und Steuerstrom auf deren Rückseite mit Gegenkontakten am Schaltschrank in Verbindung stehen.

Ausgehend von diesem Stand der Technik ist es Aufgabe der Erfindung, eine elektrische Schaltanlage sowie ein entsprechendes Basismodul für eine solche Anlage der eingangs genannten Art zu schaffen, welche einfach herstellbar sind und darüber hinaus eine möglichst gute Raumausnutzung bei guter Funktionalität gewährleisten.

Diese Aufgabe wird erfindungsgemäß gelöst durch die kennzeichnenden Merkmale der unabhängigen Ansprüche 1 und 10. Dementsprechend ist wenigstens ein Basismodul vorgesehen, welches ein von einer Bodentragschiene gebildetes Modultragprofil sowie stirnseitige und seitliche Wände aufweist, wobei eine Stirnwand des Basismoduls, vorzugsweise dessen Frontseite, von einer Steuereinheit und dessen gegenüberliegende Stirnwand von einer Messeinheit gebildet ist, und die Abmessungen der Steuer- und Messeinheiten an die Modulmaße angepasst sind. Dabei sind die beiden Längswände des Basismoduls von zwei im Hinblick auf die angestrebte gute Raumausnutzung in die in jedes Modultragprofil integrierten Rast- und Haltenuten einrastbaren Trennwänden gebildet und bilden so ein Modulgehäuse. Ferner ist im Sinne einer verbesserten Handhabung der erfindungsgemäß gestalteten elektrischen Schaltanlage eine Verrastungskugel und/oder Verriegelungsscheibe vorgesehen, welche in das Modultragprofil integriert ist und durch Einrasten in einer Bodentragschiene des Gehäuses hiermit gemeinsam eine definierte Stellungsposition bildet.

Als vorteilhaft erweist sich bei dieser Gestaltung, dass die mittels Verriegelungsscheibe oder Verrastkugel sowie Modultragprofil und Ausnehmung in der Bodenplatte gebildete Einschubverriegelung in Verbindung mit der jeweiligen Modulfront störlichtbogensicher ist.

Mit Hilfe dieser erfindungsgemäß an die jeweiligen Größenerfordernisse anpassbaren Modultechnik ist es nunmehr möglich den in dem betreffenden Schaltschrank zur Verfügung stehenden Raum bestmöglich zu nutzen. Dieser Vorteil wird dadurch verstärkt, dass in dem Basismodul sämtliche Ansteuer-, Mess- und Melde-Funktionen integriert sind.

Eine verbesserte Raumausnutzung beruht außerdem darauf, dass entsprechend einer vorteilhaften Ausgestaltung der Erfindung jedes Basismodul in dem Gehäuse mittels beiderseits am Modultragprofil angeformter Schienen im Gehäuse gehalten ist.

Hierbei ist vorteilhafterweise vorgesehen, dass am Modultragprofil ausgebildete Führungsnuten und zugeordnete Schienen im Gehäuse zusammenarbeiten und hierdurch das Basismodul beidseitig in dem als Schaltfeld vorgesehenen Geräteraum im Gehäuse geführt ist, wobei entsprechend einer zweckmäßigen Weiterbildung der Erfindung das Modultragprofil mit Rast- und Haltenuten versehen ist.

Ebenfalls zur verbesserten Handhabung des jeweiligen Moduls der erfindungsgemäßen elektrischen Schaltanlage ist an der frontseitigen Stirnseite jedes Basismoduls ein Modulgriff angeordnet, welcher das Ziehen und Schieben des betreffenden Basismoduls im Schaltfeld ermöglicht.

Diese und weitere vorteilhafte Ausgestaltungen und Verbesserungen der Erfindung sind Gegenstand der Unteransprüche.

Anhand eines in der beigefügten Zeichnung dargestellten Ausführungsbeispieles der Erfindung sollen die Erfindung, vorteilhafte Ausgestaltungen und Verbesserungen der Erfindung sowie besondere Vorteile der Erfindung näher erläutert und beschrieben werden.

Es zeigen
Fig. 1 Explosionsdarstellung eines beispielhaft ausgestalteten Basis-Einschubmodul
Fig. 2 beispielhaft ausgestaltete Bodenplatte

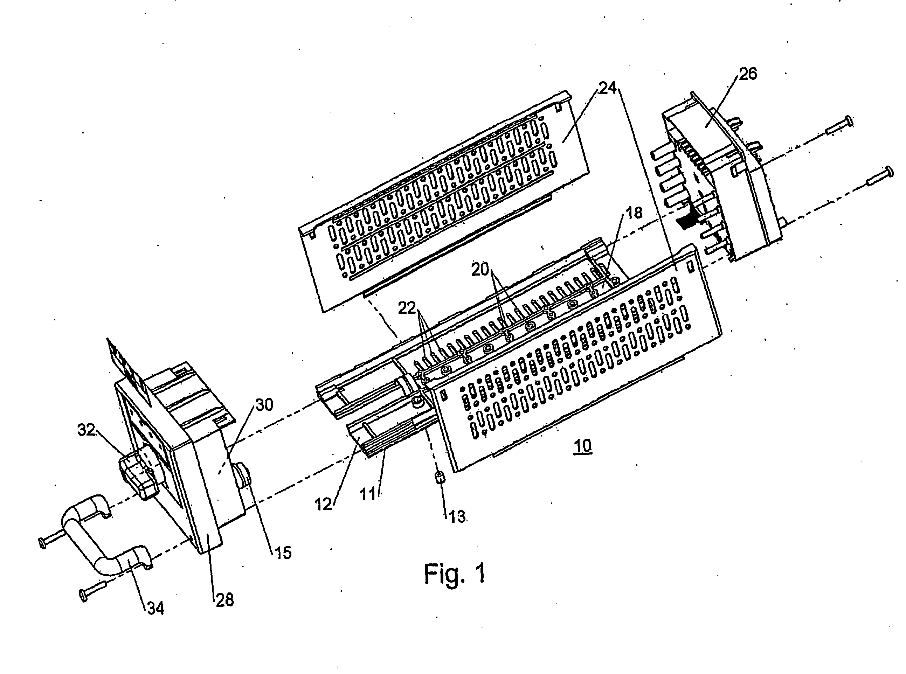

In Figur 1 ist ein beispielhaft ausgestaltetes Basis-Einschubmodul 10 in einer Explosionsdarstellung dargestellt.

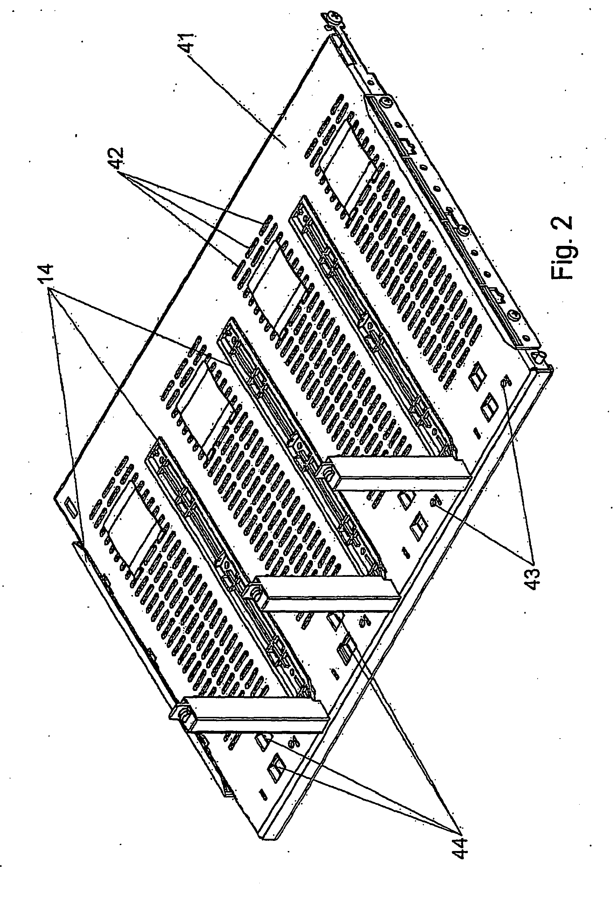

Dieses Basismodul 10 weist ein Modultragprofil 12 mit Führungsnuten 11 auf, welches von zwei parallel zueinander angeordneten Schienen 14 auf der Bodenplatte 41 (siehe Fig. 2) sicher geführt wird.

Das Modultragprofil 12, das beispielsweise aus Blech, Aluminiumguss oder auch Kunststoff gefertigt sein kann, ist mit einer längsmittig eingeformten nutähnlichen Vertiefung 18 versehen, in welche in regelmäßigem Abstand Kreisausnehmungen 20 eingeformt sind, welche beispielsweise zur Befestigung und formschlüssigen Fixierung weiterer, hier nicht näher gezeigter Komponenten und/oder Einbauten geeignet sind. Beiderseits dieser längsmittigen Vertiefung sind orthogonal hierzu Langlöcher 22 gleicher Länge und Breite in definiertem Abstand zueinander sowie zum Rand angeordnet.

Diese Langlöcher 22 sind vorgesehen, um eine optimale Durchlüftung und Kühlung des Basismoduls beziehungsweise seiner Einbauten zu gewährleisten. Sie korrespondieren mit den Langlöchern 42 (siehe Fig. 2) in der jeweiligen Bodenplatte 41 (siehe Fig. 2).

In dem Modultragprofil 12 ist eine Aufnahme für ein als Verrastkugel bezeichnetes Verrastungselement 13 vorgesehen, welches im Zusammenwirken mit entsprechenden Ausnehmungen 43 in der jeweiligen Bodenplatte 41 (siehe Fig. 2) eine definierte Positionierung des Basismoduls relativ zur Bodenplatte gewährleistet.

An den Längsseiten des Modultragprofils 12 sind mit Öffnungen versehene Seitenwände 24 vorgesehen, welche ebenfalls formschlüssig an das Modultragprofil 12 anschließen.

An der hinteren Stirnseite des Basis-Einschubmoduls 10 ist ein Abschlußteil 26 als Modulrückwand eingesetzt, welches seinerseits formschlüssig mit dem Modultragprofil 12 sowie mit den Seitenwänden 24 verbunden ist. In das Abschlussteil kann dabei vorteilhaft eine Messeinrichtung, insbesondere eine Messeinrichtung mit Mitteln zur Meßgrößen-Erfassung und/oder Meßgrößen-Vorverarbeitung, integriert sein.

Die vordere Stirnseite ist von einem Frontmodul 28 gebildet, welches ebenfalls formschlüssig mit den Modultragprofil 12 sowie mit den Seitenwänden 24 verbunden ist. In dem gezeigten Ausführungsbeispiel ist das Frontmodul 28 mit einer Steuereinrichtung 30 versehen. Mittels eines Schaltknebels 32 wird zwischen verschiedenen Betriebszuständen des Basismoduls umgeschaltet, ein im Innern des Moduls befindliches Schaltgerät geschaltet und die Verriegelungsscheibe 15 betätigt. Die Verriegelungsscheibe 15, das Modultragprofil 12 und die Ausnehmungen 44 in der Bodenplatte 41 (vgl. Fig. 2) wirken zusammen und stellen sicher, dass das Basismodul 10 im jeweiligen Geräteraum der Schaltanlage, beispielsweise ein Schaltschrank, Lichtbogensicher verrastet.

Zur Handhabung des Basis-Einschubmoduls 10 dient ein an das Frontmodul 28 angeschraubter Handgriff 34.

In Fig. 2 ist in perspektivischer Darstellung eine Bodenplatte 41, mit parallel zueinander angeordneten Schienen 14 zur Führung des Basis-Einschubmoduls 10 bzw. der Führungsnuten 11 des Modultragprofils geneigt.

Darüber hinaus sind die Ausnehmungen 43 in der Bodenplatte 41 angegeben, die im zusammenwirken mit dem Verrastungselement 13 eine definierte Positionierung des Basismoduls relativ zur Bodenplatte bewirken.

Auch die Ausnehmungen 44 in der Bodenplatte 41, die mit der Verriegelungsscheibe 15 und dem Modultragprofil 12 zusammenwirken und sicherstellen, dass das Basismodul 10 im jeweiligen Geräteraum der Schaltanlage, beispielsweise ein Schaltschrank, Lichtbogensicher verrastet, sind angegeben.

## Patentansprüche

1. Elektrische Schaltanlage mit einem Gehäuse und mit darin angeordneten Komponenten, die als Steuer- und/oder Messeinheit ausgebildet sind, wobei die Komponenten in modulartigen Einschüben angeordnet sind, welche ein als Bodenteil dienendes Modultragprofil sowie bedarfsweise seitliche Begrenzungen (24) und eine Bodenplatte (h1) aufweisen,
**dadurch gekennzeichnet,**
**dass** wenigstens ein Basismodul (10).

2. Elektrische Schaltanlage nach Anspruch 1, **dadurch gekennzeichnet, dass** jedes Basismodul (10) in dem Gehäuse mittels zweier zueinander paralleler zum Modultragprofil (12) gehörender Schienen (14) gehalten ist.

3. Elektrische Schaltanlage nach einem der vorherigen Ansprüche, **dadurch gekennzeichnet, dass** die zum Modultragprofil (12) gehörenden Führungsnuten (11) mit zugeordneten Schienen (14) an der Bodenplatte (41) zusammenwirken und hierdurch das Basismodul (10) beidseitig in dem als Schaltfeld vorgesehenen Geräteraum im Gehäuse geführt ist.

4. Elektrische Schaltanlage nach Anspruch 1 oder 2, **dadurch gekennzeichnet, dass** das Modultragprofil (12) mit kreisförmigen Ausnehmungen (20) und Langlöchern versehen ist.

5. Elektrische Schaltanlage nach einem der vorherigen Ansprüche, **dadurch gekennzeichnet, dass** die beiden Längswände (24) des Basismoduls (10) von zwei einrastbaren Trennwänden gebildet sind.

6. Elektrische Schaltanlage nach einem der vorherigen Ansprüche, **dadurch gekennzeichnet, dass** eine Verriegelungsscheibe (15) durch Einrasten in eine Ausnehmung (44) in der Bodenplatte (41) des Gehäuses gemeinsam eine Einschubverriegelung bildet.

7. Elektrische Schaltanlage nach einem der vorherigen Ansprüche, **dadurch gekennzeichnet, dass** die mittels Verriegelungsscheibe(15), Modultragprofil (12) und Bodenplatte (41) gebildete Einschubverriegelung störlichtbogensicher ist.

8. Elektrische Schaltanlage nach einem der vorherigen Ansprüche, **dadurch gekennzeichnet, dass** an der frontseitigen Stirnseite jedes Basismoduls ein Modulgriff (32) angeordnet ist, welcher das Positionieren des betreffenden Basismoduls (10) im Schaltfeld ermöglicht.

9. Elektrische Schaltanlage nach einem der vorherigen Ansprüche, **dadurch gekennzeichnet, dass** in dem Basismodul sämtliche Ansteuer-, Mess- und Melde-Funktionen integriert sind.

10. Basismodul mit wenigsten einem Modultragprofil (12) sowie mit Seitenwänden (24) und mit stirnseitigen Einsätzen (26, 28) vorgesehen ist, wobei das Basismodul (10) auf der Bodenplatte (A1) sieher
geführt wird, dass eine Stirnwand (28) des Basismoduls, vorzugsweise dessen Frontseite, von einer Steuereinheit und dessen gegenüberliegende Stirnwand (26) von einer Messeinheit gebildet ist,
dass die Abmessungen der Steuer- und Messeinheiten an die Modulmasse angepasst sind,
dass Seitenwände (24) mit in jedem Modultragprofil (12) vorgesehenen Haltenuten zusammenarbeiten und ein Modulgehäuse bilden und dass eine Verrastungskugel (13) und/oder Verriegelungsscheibe als Halteelement für eine definierte Stellung bzw. Position des Basismoduls (10) vorgesehen ist, welche mit dem Modultragprofil (12) und entsprechenden Ausnehmungen (43) in der Bodenplatte (41) zusammenwirkt für eine elektrische Schaltanlage, insbesondere eine Mitteloder Niederspannungsschaltanlage, gemäß einem der Ansprüche 1 bis 9.

## Claims

1. An electric switching system, comprising a housing and components arranged therein as control and/or measuring unit, with the components being arranged in modular racks which comprise a module support profile used as a base part and optionally lateral boundary walls (24) and a base plate (41), **characterized in that** at least one base module (10) is provided with at least one module support profile (12) and with side walls (24) and inserts (26, 28) on the face side, with the base module (10) being securely guided on the base plate (41), a face wall (28) of the base module, preferably its front side, is formed by a control unit and its opposite face wall (26) by a measuring unit, the dimensions of the control and measuring unit are adjusted to the mass of the module, side walls (24) cooperate with holding grooves provided in each module support profile (12) and form a module housing, and a locking ball (13) and/or locking disk is provided as a holding element for a defined position of the base module (10) which cooperates with the module support profile (12) and respective recesses (43) in the base plate (41).

2. An electric switching system according to claim 1, **characterized in that** each base module (10) is held by means of two rails (14) which are parallel with respect to each other and belong to the module support profile (12).

3. An electric switching system according to one of the preceding claims, **characterized in that** the guide grooves (11) belonging to the module support profile (12) cooperate with associated rails (14) on the base plate (41) and thereby the base module (10) is guided on both sides in the component space in the housing provided as a control panel.

4. An electric switching system according to claim 1 or 2, **characterized in that** the module support profile (12) is provided with circular recesses (20) and oblong holes.

5. An electric switching system according to one of the preceding claims, **characterized in that** the two longitudinal walls (24) of the base module (10) is formed by two snap-in separating walls.

6. An electric switching system according to one of the preceding claims, **characterized in that** a locking disk (15), by latching into a recess (44) in the base plate (41) of the housing, jointly forms a slide-in latch.

7. An electric switching system according to one of the preceding claims, **characterized in that** the slide-in latch formed by means of the locking disk (15), module support profile (12) and base plate (41) is fault-arc-proof.

8. An electric switching system according to one of the preceding claims, **characterized in that** a module handle (32) is arranged on the front face side of each base module, which handle enables the positioning of the respective base module (10) in the control panel.

9. An electric switching system according to one of the preceding claims, **characterized in that** all triggering, measuring and signaling functions are integrated in the base module.

10. A base module with at least one base module (10) with at least one module support profile (12) and with side walls (24) and inserts (26, 28) on the face side, with the base module (10) being securely guided on the base plate (41), a face wall (28) of the base module, preferably its front side, is formed by a control unit and its opposite face wall (26) by a measuring unit, the dimensions of the control and measuring unit are adjusted to the mass of the module, side walls (24) cooperate with holding grooves provided in each module support profile (12) and form a module housing, and a locking ball (13) and/or locking disk is provided as a holding element for a defined position of the base module (10) which cooperates with the module support profile (12) and respective recesses (43) in the base plate (41), for an electric switching system, especially a medium-voltage or low-voltage switching system, according to one of the claims 1 to 9.

## Revendications

1. Installation de commutation électrique avec un boîtier et avec des composants disposés dans celui-ci, qui est conçue comme une unité de commande et/ou de mesure, les composants étant disposés dans des tiroirs modulaires qui présentent un profilé de support du module servant de partie de fond, ainsi que des délimitations latérales (24) et une plaque de fond (41) si nécessaire,
**caractérisée en ce qu'**il est prévu au moins un module de base (10) avec au moins un profilé de support de module (12) et avec des parois latérales (24) et des inserts (26, 28) sur la face d'extrémité, lequel module de base (10) est guidé de manière sûre sur la plaque de fond (41),
**en ce qu'**une face d'extrémité (28) du module de base, de préférence sa face avant, est formée par une unité de commande et la face d'extrémité (26) opposée par une unité de mesure,
**en ce que** les dimensions des unités de commande et de mesure sont adaptées aux cotes du module,
**en ce que** les parois latérales (24) coopèrent avec des gorges de maintien prévues dans chaque profilé de support de module (12) et forment un boîtier de module et
**en ce qu'**une bille d'engagement (13) et/ou un disque de verrouillage sont prévus comme élément de maintien pour une position définie du module de base (10), qui coopère avec le profilé de support de module (12) et des creux (43) correspondants dans la plaque de fond (41).

2. Installation de commutation électrique selon la revendication 1, **caractérisée en ce que** chaque module de base (10) est retenu dans le boîtier au moyen de deux rails (14) parallèles faisant partie du profilé de support de module (12).

3. Installation de commutation électrique selon l'une des revendications précédentes, **caractérisée en ce que** les gorges de guidage (11) faisant partie du profilé de support de module (12) coopèrent avec des rails (14) associés sur la plaque de fond (41) et le module de base (10) est ainsi guidé des deux côtés dans le compartiment d'appareillage du boîtier prévu pour servir de tableau de commutation.

4. Installation de commutation électrique selon la revendication 1 ou 2, **caractérisée en ce que** le profilé de support de module (12) est doté d'évidements circulaires (20) et de trous oblongs.

5. Installation de commutation électrique selon l'une des revendications précédentes, **caractérisée en ce que** les deux parois longitudinales (24) du module de base (10) sont formées par deux cloisons pouvant être emboîtées.

6. Installation de commutation électrique selon l'une des revendications précédentes, **caractérisée en ce qu'**un disque de verrouillage (15) forme en s'emboîtant dans un évidement (44) dans la plaque de fond (41) du boîtier un verrouillage d'insertion avec celle-ci.

7. Installation de commutation électrique selon l'une des revendications précédentes, **caractérisée en ce que** le verrouillage d'insertion formé par le disque de verrouillage (15), le profilé de support de module (12) et la plaque de fond (41) est insensible aux arcs électriques parasites.

8. Installation de commutation électrique selon l'une des revendications précédentes, **caractérisée en ce qu'**il est prévu sur la face d'extrémité avant de chaque module de base une poignée de module (32) qui permet de positionner le module de base (10) en question dans le tableau de commutation.

9. Installation de commutation électrique selon l'une des revendications précédentes, **caractérisée en ce que** toutes les fonctions d'activation, de mesure et de signalisation sont intégrées dans le module de base.

10. Module de base avec au moins un module de base (10) avec au moins un profilé de support de module (12) et avec des parois latérales (24) et des inserts (26, 28) sur la face d'extrémité, lequel module de base (10) est guidé de manière sûre sur la plaque de fond (41),
dans lequel une face d'extrémité (28) du module de base, de préférence sa face avant, est formée par une unité de commande et la face d'extrémité (26) opposée par une unité de mesure,
dans lequel les dimensions des unités de commande et de mesure sont adaptées aux cotes du module,
dans lequel les parois latérales (24) coopèrent avec des gorges de maintien prévues dans chaque profilé de support de module (12) et forment un boîtier de module et
dans lequel une bille d'engagement (13) et/ou un disque de verrouillage sont prévus comme élément de maintien pour une position définie du module de base (10), qui coopère avec le profilé de support de module (12) et des creux (43) correspondants dans la plaque de fond (41),
pour une installation de commutation électrique, en particulier une installation de commutation moyenne ou basse tension selon l'une des revendications 1 à 9.
